# EUROPEAN PATENT APPLICATION

(11) **EP 4 310 890 A1**
(43) Date of publication of application: **24.01.2024**
(21) Application number: 21931536.3
(22) Date of filing: 17.03.2021
(51) Int. Cl.: H01L 21/31, H01L 21/318

(54) **CLEANING METHOD, SEMICONDUCTOR DEVICE PRODUCTION METHOD, SUBSTRATE TREATMENT DEVICE, AND PROGRAM**

(71) Applicant: Kokusai Electric Corporation, Tokyo 101-0045 (JP)
(72) Inventor: KOSHI, Yasunobu, Toyama-shi, Toyama 939-2393 (JP); URANO, Yuji, Toyama-shi, Toyama 939-2393 (JP); NOHARA, Shingo, Toyama-shi, Toyama 939-2393 (JP); HARADA, Kazuhiro, Toyama-shi, Toyama 939-2393 (JP)
(74) Representative: Bardehle Pagenberg Partnerschaft mbB Patentanwälte Rechtsanwälte
(86) International application number: PCT/JP2021/010933
(87) International publication number: WO 2022/195785

(57) **Abstract**

The cleaning method for cleaning a treatment chamber in which a film formation treatment is performed on a substrate includes: a heating step in which the inside of the treatment chamber, which is to be supplied with cleaning gas, is divided into three or more zones in a gas flow direction, and the inside of the treatment chamber is heated such that, inside the treatment chamber, the temperature difference between the zone positioned on the upstream side in the gas flow direction and the zone adjacent to said zone is greater than the temperature difference between the zone positioned on the downstream side in the gas flow direction and the zone adjacent to said zone; and a step in which, after the heating step, the inside of the treatment chamber is supplied with cleaning gas.

## Description

### TECHNICAL FIELD

The present disclosure relates to a cleaning method, a method of manufacturing a semiconductor device, a substrate processing apparatus, and a program.

### BACKGROUND

As a process of manufacturing a semiconductor device, a film-forming process may be performed to form a film on a substrate by supplying a precursor gas and a reaction gas to the substrate in a process chamber. When the film-forming process is performed, deposits containing a film-forming material may adhere to an inner surface of the process chamber. Therefore, there is a known method of cleaning the inside of the process chamber by supplying a cleaning gas into the process chamber in which substrates are processed after performing the film-forming process (for example, *see* Japanese laid-open publication No. 2007-13205 and Japanese laid-open publication No. 2012-216696).

### SUMMARY

In a film-forming process after cleaning, processing on each substrate may become uneven.

The present disclosure provides some embodiments of a technique of making processing on each substrate substantially uniform in a substrate processing process after cleaning.

According to some embodiments of the present disclosure, there is provided a method of cleaning a process chamber in which a film-forming process is performed on a substrate, including: dividing an inside of the process chamber, into which a cleaning gas is to be supplied, into three or more zones in a gas flow direction and heating the inside of the process chamber such that, in the process chamber, a temperature difference between a zone positioned on an upstream side in the gas flow direction and a zone adjacent to the zone positioned on the upstream side is greater than a temperature difference between a zone positioned on a downstream side in the gas flow direction and a zone adjacent to the zone positioned on the downstream side; and supplying the cleaning gas into the process chamber after the act of heating.

According to the present disclosure, it is possible to make processing on each substrate substantially uniform in a substrate processing process after cleaning.

### BRIEF DESCRIPTION OF DRAWINGS

FIG. 1 is a schematic configuration view of a substrate processing apparatus according to some embodiments of the present disclosure.
FIG. 2 is a view showing a flow of a cleaning gas in a process furnace shown in FIG. 1.
FIG. 3 is a view showing a state in which a cleaning gas is supplied from a second nozzle into a process chamber in the process furnace shown in FIG. 1.
FIG. 4 is a diagram showing a configuration of a controller of a substrate processing apparatus according to the embodiments of the present disclosure.
FIG. 5 is a flowchart of a substrate processing process according to embodiments of the present disclosure.
FIG. 6 is a graph showing a relationship between a cumulative film thickness and a film thickness variation rate in a process chamber in a substrate processing apparatus according to a comparative example.
FIG. 7 is a graph showing a relationship between a cumulative film thickness and a film thickness variation rate in a process chamber in a substrate processing apparatus of an example.
FIG. 8 is a longitudinal cross-sectional view of a process furnace included in a substrate processing apparatus according to other embodiments of the present disclosure.

### DETAILED DESCRIPTION

Embodiments of the present disclosure will now be described with reference to the drawings. The drawings used in the following description are schematic, and dimensional relationships, ratios, and the like of the respective components shown in the drawings may not match actual ones. Further, dimensional relationships, ratios, and the like of various components among plural drawings may not match one another.

### <Substrate Processing Apparatus>

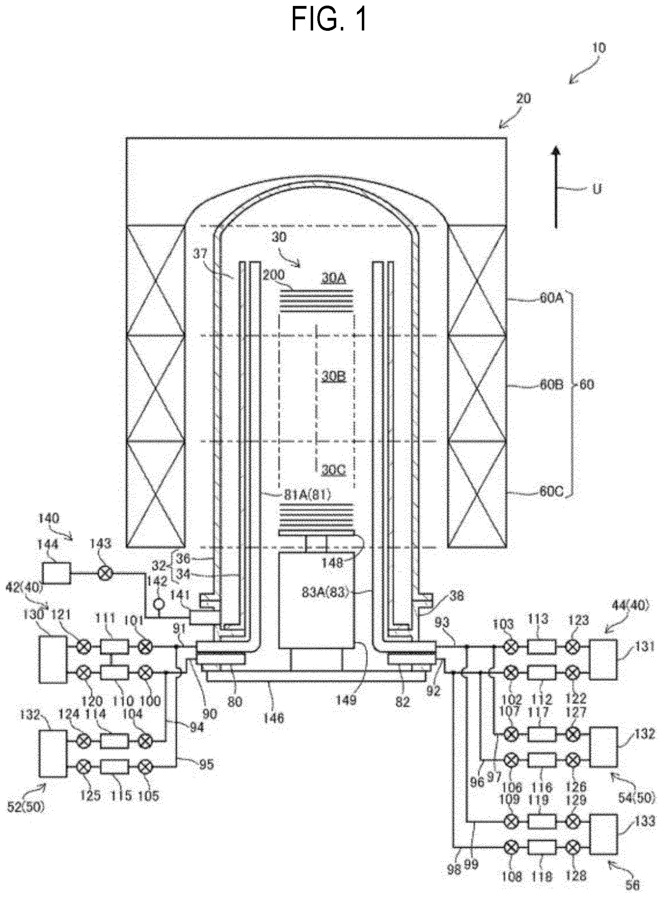

FIG. 1 is a view showing a substrate processing apparatus 10 according to the embodiments of the present disclosure. This substrate processing apparatus 10 is used when manufacturing a semiconductor device. Specifically, the substrate processing apparatus 10 according to the embodiments of the present disclosure is configured as a batch-type vertical heat treatment apparatus.

The substrate processing apparatus 10 according to the embodiments of the present disclosure includes a process furnace 20, as shown in FIG. 1. This process furnace 20 includes a process chamber 30, a process gas supply system 40, a cleaning gas supply system 50, a heater 60 as a heating part, and a controller 70 as a control part.

### (Process Chamber)

The process furnace 20 includes a reaction tube 32 as a process container, as shown in FIG. 1. This reaction tube 32 is installed in the process furnace 20 with a vertical direction of the process furnace 20 as an axial direction (that is, a tube axial direction). Further, the reaction tube 32 includes an inner tube 34 and an outer tube 36.

The inner tube 34 is formed in a tubular shape (cylindrical shape in the embodiments). An internal space of this inner tube 34 constitutes the process chamber 30. The process chamber 30 processes a wafer 200 as a substrate. The process chamber 30 is configured to be capable of accommodating a boat 148 to be described later, which is an example of a substrate holder configured to be capable of holding the wafers 200 in such a state the wafers 200 are aligned in a horizontal posture and in multiple stages along a vertical direction.

Further, the inner tube 34 is made of a heat-resistant material. Examples of materials forming the inner tube 34 may include quartz (SiO₂), silicon carbide (SiC), and the like.

The outer tube 36 is formed in a tubular shape (cylindrical shape in the embodiments) with its upper end closed. This outer tube 36 is disposed radially outside the inner tube 34 so as to surround the inner tube 34. Further, the outer tube 36 is disposed to be concentric with the inner tube 34. As shown in FIG. 1, a gap is formed between the inner tube 34 and the outer tube 36.

Further, the outer tube 36 is made of a heat-resistant material. Examples of materials forming the outer tube 36 may include quartz (SiO₂), silicon carbide (SiC), and the like. In the embodiments of the present disclosure, the inner tube 34 and the outer tube 36 are made of the same heat-resistant material, but the present disclosure is not limited thereto.

A manifold 38 is provided to be concentric with the outer tube 36 under the outer tube 36. The manifold 38 is formed in a cylindrical shape with its upper and lower ends opened. Further, the manifold 38 engages with the inner tube 34 and the outer tube 36 to support the inner tube 34 and the outer tube 36. Examples of materials forming the manifold 38 may include metal materials such as a nickel alloy and stainless steel, heat-resistant materials such as quartz and SiC, or the like. Further, an O-ring (not shown) as a seal is provided between the manifold 38 and the outer tube 36. Further, the manifold 38 is supported by a support (not shown) of the process furnace 20, such that the reaction tube 32 is installed vertically with the vertical direction as the axial direction.

### (Process Gas Supply System)

The process gas supply system 40 is configured to supply a process gas (precursor gas) into the process chamber. The process gas supply system 40 includes a first process gas supply system 42 and a second process gas supply system 44.

The first process gas supply system 42 includes at least a nozzle 80 as a first gas supply nozzle, a gas supply pipe 90, a valve 100, a MFC 110, and a valve 120, which are shown in FIG. 1. Further, a nozzle 81 as a second gas supply nozzle, a gas supply pipe 91, a valve 101, a MFC 111, and a valve 121, which are shown in FIG. 1, may be included in the first process gas supply system 42. Further, a first process gas supply source 130 may be included in the first process gas supply system 42.

The nozzle 80 is connected to a peripheral wall of the manifold 38 and is in fluid communication with the inside of the process chamber 30. Therefore, a first process gas is supplied into the process chamber 30 via the nozzle 80. The gas supply pipe 90 is connected to an upstream end of the nozzle 80 in a flow direction of the first process gas. At The gas supply pipe 90 is provided with the first process gas supply source 130, the valve 120, the MFC (mass flow controller) 110 as a gas flow rate controller, and the valve 100 sequentially from the upstream side in the flow direction of the first process gas. The nozzle 80 is an example of the first nozzle of the present disclosure.

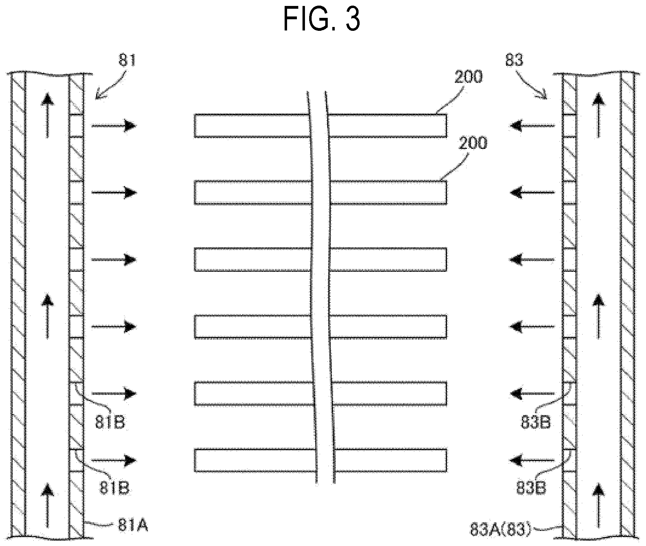

The nozzle 81 penetrates the peripheral wall of the manifold 38 and extends from the lower side toward the upper side of the process chamber 30 to be in fluid communication with the inside of the process chamber 30. Specifically, the nozzle 81 is formed in an L shape such that it penetrates the peripheral wall of the manifold 38, extends in the horizontal direction, is bent in the middle, and extends from the lower side to the upper side of the process chamber 30 along the axial direction of the reaction tube 32. Further, as shown in FIG. 3, a vertical side 81A of the nozzle 81 extending from the lower side to the upper side of the process chamber 30 is provided with a plurality of injection ports 81B spaced apart in a direction (the axial direction of the reaction tube 32 in the embodiments) in which the vertical side 81A extends. The first process gas supplied to the nozzle 81 is supplied into the process chamber 30 from the plurality of injection ports 81B. Here, since the injection ports 81B are respectively formed in portions of the vertical side 81A corresponding to at least a middle zone 30B and an upper zone 30A in the process chamber 30, the first process gas may be directly supplied to the middle zone 30B and the upper zone 30A of the process chamber 30. The gas supply pipe 91 is connected to the upstream end of the nozzle 81 in the flow direction of the first process gas. This gas supply pipe 91 is provided with the first process gas supply source 130, the valve 121, the MFC (mass flow controller) 111 as a gas flow rate controller, and the valve 101 sequentially from the upstream side in the flow direction of the first process gas. The nozzle 81 is an example of the second nozzle of the present disclosure. The nozzle 81 may not be installed in the present disclosure. By providing the nozzle 81 and supplying the first process gas from the nozzle 81, processing uniformity for each wafer 200 may be improved.

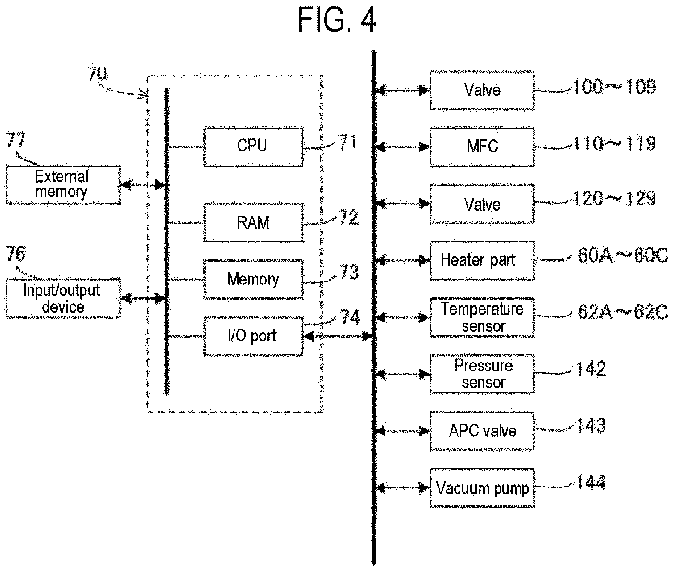

The MFC 110, the valves 100 and 120, the MFC 111, and the valves 101 and 121 are each electrically connected to the controller 70 to be described later *(see* FIG. 4). The controller 70 is configured to control each of the MFC 110, the valves 100 and 120, the MFC 111, and the valves 101 and 121 such that a flow rate of the first process gas supplied into the process chamber 30 becomes a predetermined flow rate at a predetermined timing.

The second process gas supply system 44 includes at least a nozzle 82 as the first gas supply nozzle, a gas supply pipe 92, a valve 102, a MFC 112, and a valve 122, which are shown in FIG. 1. Further, a nozzle 83 as the second gas supply nozzle, a gas supply pipe 93, a valve 103, a MFC 113, and a valve 123 may be included in the second process gas supply system 44. Further, a second process gas supply source 131 may be included in the second process gas supply system 44.

The nozzle 82 is connected to the peripheral wall of the manifold 38 and is in fluid communication with the inside of the process chamber 30. Therefore, a second process gas is supplied into the process chamber 30 via the nozzle 82. The gas supply pipe 92 is connected to an upstream end of the nozzle 82 in the flow direction of the second process gas. The gas supply pipe 92 is provided with the second process gas supply source 131, the valve 122, the MFC (mass flow controller) 112 as a gas flow rate controller, and the valve 102 sequentially from the upstream side in the flow direction of the second process gas. The nozzle 82 is an example of the first nozzle of the present disclosure.

The nozzle 83 penetrates the peripheral wall of the manifold 38 and extends from the lower side toward the upper side of the process chamber 30 to be in fluid communication with the inside of the process chamber 30. Specifically, the nozzle 83 is formed in an L shape such that it penetrates the peripheral wall of the manifold 38, extends in the horizontal direction, is bent in the middle, and extends from the lower side to the upper side of the process chamber 30 along the axial direction of the reaction tube 32. Further, as shown in FIG. 3, a vertical side 83A of the nozzle 83 extending from the lower side to the upper side of the process chamber 30 is provided with a plurality of injection ports 83B spaced apart in a direction (the axial direction of the reaction tube 32 in the embodiments) in which the vertical side 83A extends. The second process gas supplied to the nozzle 83 is supplied into the process chamber 30 from the plurality of injection ports 83B. Here, since the injection ports 83B are respectively formed in portions of the vertical side 83A corresponding to at least the middle zone 30B and the upper zone 30A in the process chamber 30, the first process gas may be directly supplied to the middle zone 30B and the upper zone 30A of the process chamber 30. The gas supply pipe 93 is connected to the upstream end of the nozzle 83 in the flow direction of the second process gas. This gas supply pipe 93 is provided with the second process gas supply source 131, the valve 123, the MFC (mass flow controller) 113 as a gas flow rate controller, and the valve 103 sequentially from the upstream side in the flow direction of the second process gas. The nozzle 83 is an example of the second nozzle of the present disclosure. The nozzle 83 may not be installed in the present disclosure. By providing the nozzle 83 and supplying the second process gas from the nozzle 83, processing uniformity for each wafer 200 may be improved.

The MFC 112, the valves 102 and 122, the MFC 113, and the valves 103 and 123 are each electrically connected to the controller 70 (*see* FIG. 4). The controller 70 is configured to control each of the MFC 112, the valves 102 and 122, the MFC 113, and the valves 103 and 123 such that the flow rate of the second process gas supplied into the process chamber 30 becomes a predetermined flow rate at a predetermined timing.

### (Cleaning Gas Supply System)

The cleaning gas supply system 50 is configured to supply a cleaning gas into the process chamber 30. This cleaning gas supply system 50 includes a first cleaning gas supply system 52 and a second cleaning gas supply system 54, as shown in FIG. 1.

The first cleaning gas supply system 52 mainly includes the nozzle 80, a gas supply pipe 94, a valve 104, a MFC 114, and a valve 124. Further, the nozzle 81, a gas supply pipe 95, a valve 105, a MFC 115, and a valve 125 may be included in the first cleaning gas supply system 52. Further, a cleaning gas supply source 132 may be included the first cleaning gas supply system 52.

As shown in FIG. 1, the gas supply pipe 94 configured to supply the cleaning gas into the process chamber 30 is connected between the valve 100 of the gas supply pipe 90 and the nozzle 80. The gas supply pipe 94 is provided with the cleaning gas supply source 132, the valve 124, the MFC (mass flow controller) 114 as a gas flow rate controller, and the valve 104 sequentially from the upstream side in the flow direction of the cleaning gas.

The gas supply pipe 95 configured to supply the cleaning gas into the process chamber 30 is connected between the valve 101 of the gas supply pipe 91 and the nozzle 81. The gas supply pipe 95 is provided with the cleaning gas supply source 132, the valve 125, the MFC (mass flow controller) 115 as a gas flow rate controller, and the valve 105 sequentially from the upstream side in the flow direction of the cleaning gas.

The MFC 114, the valves 104 and 124, the MFC 115, and the valves 105 and 125 are each electrically connected to the controller 70 (*see* FIG. 4). The controller 70 is configured to control each of the MFC 114, the valves 104 and 124, the MFC 115, and the valves 105 and 125 such that the flow rate of the cleaning gas supplied into the process chamber 30 becomes a predetermined flow rate at a predetermined timing.

The second cleaning gas supply system 54 includes at least the nozzle 82, a gas supply pipe 96, a valve 106, a MFC 116, and a valve 126. Further, the nozzle 83, a gas supply pipe 97, a valve 107, a MFC 117, and a valve 127 may be included in the second cleaning gas supply system 54. Further, the cleaning gas supply source 132 may be included in the second cleaning gas supply system 54.

As shown in FIG. 1, the gas supply pipe 96 configured to supply the cleaning gas into the process chamber 30 is connected between the valve 102 of the gas supply pipe 92 and the nozzle 82. The gas supply pipe 96 is provided with the cleaning gas supply source 132, the valve 126, the MFC (mass flow controller) 116 as a gas flow rate controller, and the valve 106 sequentially from the upstream side in the flow direction of the cleaning gas.

The gas supply pipe 97 configured to supply the cleaning gas into the process chamber 30 is connected between the valve 103 of the gas supply pipe 93 and the nozzle 83. The gas supply pipe 97 is provided with the cleaning gas supply source 132, the valve 127, the MFC (mass flow controller) 117 as a gas flow rate controller, and the valve 107 sequentially from the upstream side in the flow direction of the cleaning gas.

The MFC 116, the valves 106 and 126, the MFC 117, and the valves 107 and 127 are each electrically connected to the controller 70 (*see* FIG. 4). The controller 70 is configured to control each of the MFC 116, the valves 106 and 126, the MFC 117, and the valves 107 and 127 such that the flow rate of the cleaning gas supplied into the process chamber 30 becomes a predetermined flow rate at a predetermined timing.

With such a configuration, the cleaning gas is supplied from the upstream side (lower side) toward the downstream side (upper side) of the process chamber 30.

In the embodiments of the present disclosure, one cleaning gas supply source is used in a plurality of cleaning gas supply systems, but the present disclosure is not limited thereto, and one cleaning gas supply source may be used for each cleaning gas supply system.

### (Inert Gas Supply System)

The process furnace 20 also includes an inert gas supply system 58. The inert gas supply system 58 is configured to supply an inert gas into the process chamber 30.

The inert gas supply system 58 includes at least the nozzle 82, a gas supply pipe 98, a valve 108, a MFC 118, and a valve 128. The nozzle 83, a gas supply pipe 99, a valve 109, a MFC 119, and a valve 129 may be included in the inert gas supply system 58. Further, an inert gas supply source 133 may be included in the inert gas supply system 58.

As shown in FIG. 1, the gas supply pipe 98 configured to supply the inert gas into the process chamber 30 is connected between the valve 102 of the gas supply pipe 92 and the nozzle 82. The gas supply pipe 98 is provided with the inert gas supply source 133, the valve 128, the MFC (mass flow controller) 118 as a gas flow rate controller, and the valve 108 sequentially from the upstream side in the flow direction of the inert gas.

The gas supply pipe 99 configured to supply the inert gas into the process chamber 30 is connected between the valve 103 of the gas supply pipe 93 and the nozzle 83. The gas supply pipe 99 is provided with the inert gas supply source 133, the valve 129, the MFC (mass flow controller) 119 as a gas flow rate controller, and the valve 109 sequentially from the upstream side in the flow direction of the inert gas.

The MFC 118, the valves 108 and 128, the MFC 119, and the valves 109 and 129 are each electrically connected to the controller 70 (*see* FIG. 4). The controller 70 is configured to control each of the MFC 118, the valves 108 and 128, the MFC 119, and the valves 109 and 129 such that the flow rate of the cleaning gas supplied into the process chamber 30 becomes a predetermined flow rate at a predetermined timing.

For example, a nitrogen (N₂) gas may be used as the inert gas.

### (Exhaust System)

The process furnace 20 also includes an exhaust system 140, as shown in FIG. 1. The exhaust system 140 is configured to exhaust the internal atmosphere of the process chamber 30. Further, the exhaust system 140 mainly includes an exhaust pipe 141, a pressure sensor 142, an APC valve 143, and a vacuum pump 144.

The exhaust pipe 141 is connected to the peripheral wall of the manifold 38. Further, the exhaust pipe 141 is disposed at the lower end side of a tubular space 37 formed by the gap between the inner pipe 34 and the outer pipe 36 and is in fluid communication with the tubular space 37. With this configuration, the exhaust pipe 141 exhausts the internal atmosphere of the process chamber 30 via the tubular space 37.

The vacuum pump 144 as a vacuum exhauster is installed on the side opposite a connection side of the exhaust pipe 141 with the manifold 38 via the pressure sensor 142 as a pressure detector and the APC valve 143 as a pressure regulator.

The vacuum pump 144 is configured to exhaust the inside of the process chamber 30 to a predetermined pressure (state of vacuum). The controller 70 is electrically connected to the APC valve 143 and the pressure sensor 142. The controller 70 is configured to control the APC valve 143 at a desired timing based on the pressure information detected by the pressure sensor 142 such that the internal pressure of the process chamber 30 becomes a desired pressure.

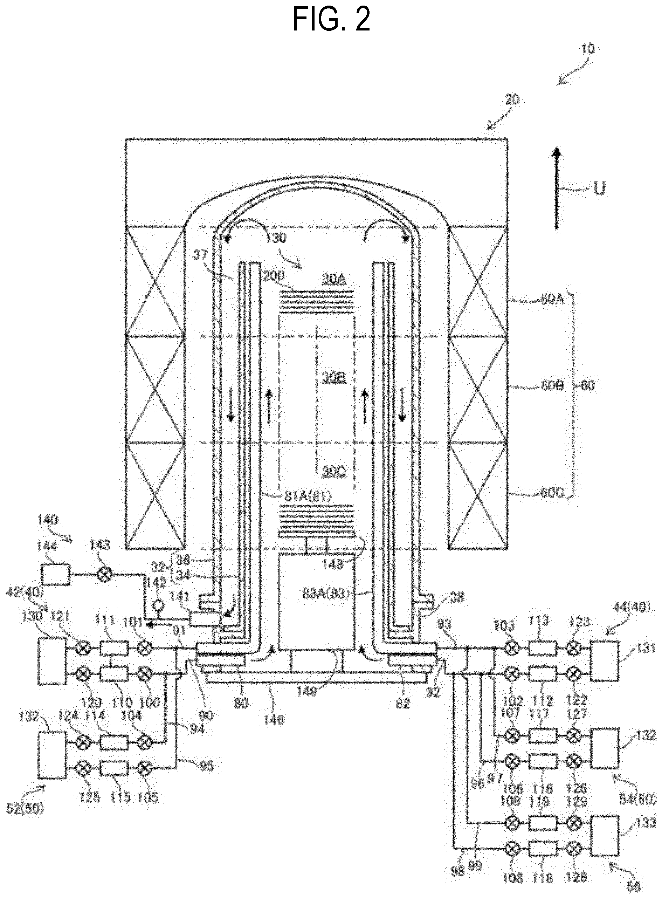

With the configuration as described above, the first process gas supplied from the first process gas supply system, the second process gas supplied from the second process gas supply system, the cleaning gas supplied from the cleaning gas supply system, and the inert gas supplied from the inert gas supply system rise in the inner space of the inner pipe 34 (the inside of the process chamber 30), flow out from the upper end opening of the inner pipe 34 into the tubular space 37, flow down the tubular space 37, and then are discharged from the exhaust pipe 141 (*see* FIG. 2).

A seal cap 146 as a furnace opening lid capable of hermetically closing the lower end opening of the manifold 38 is provided under the manifold 38. The seal cap 146 is in contact with the lower end of the manifold 38 from below in the vertical direction. Further, the seal cap 146 is formed in a disc shape. Examples of materials constituting the seal cap 146 may include metal materials such as stainless steel. An O-ring (not shown) as a seal in contact with the lower end of the manifold 38 is installed on an upper surface of the seal cap 146.

A support stand 149 configured to support the boat 148 is installed on the seal cap 146. The support stand 149 is made of a heat-resistant material. Examples of materials constituting the support stand 149 may include quartz, silicon carbide (SiC), and the like. The support stand 149 functions as a heat insulator that makes it difficult for heat from the heater 60 to be transferred to the manifold 38.

As described above, the boat 148 is configured to be capable of holding the plurality of wafers 200 in such a state that the wafers 200 are arranged in the horizontal posture and in multiple stages with centers of the wafers 200 aligned with one another. The boat 148 is made of, for example, a heat-resistant material such as quartz or silicon carbide.

Further, a rotator (not shown) configured to rotate the boat 148 and a boat elevator (not shown) configured to raise or lower the boat 148 are provided below the seal cap 146. The rotator may perform the rotating operation to rotate the boat 148 within the process chamber 30. Further, the boat elevator may perform the raising/lowering operation to move the boat 148 into or out of the process chamber 30.

### (Heater)

The heater 60 as a heating part is formed in a tubular shape (cylindrical shape in the embodiments). The heater 60 is disposed radially outside the reaction tube 32 so as to surround the reaction tube 32. Further, the heater 60 is disposed to be concentric with the reaction tube 32.

As shown in FIG. 1, the heater 60 is configured to be capable of dividing the inside of the process chamber 30 into three or more zones in the gas flow direction of the cleaning gas and heating each zone separately. Specifically, the heater 60 according to the embodiments is divided into three parts in the axial direction, namely a heater part 60A, a heater part 60B, and a heater part 60C sequentially from the top. These heater parts 60A, 60B, and 60C are individually controlled by the controller 70. Specifically, the controller 70 is configured to be capable of adjusting a heat generation temperature of each heater part by controlling supply of power to each heater wire installed at each heater part (for example, controlling on/off of a thyristor). Then, a range of the process chamber 30 that is heated by the heater part 60A is the upper zone 30A of the process chamber 30, a range of the process chamber 30 that is heated by the heater part 60B is the middle zone 30B of the process chamber 30, and a range of the process chamber 30 that is heated by the heater part 60C is the lower zone 30C of the process chamber 30. The upper zone 30A is a zone of the process chamber 30 positioned on the downstream side in the flow direction of the cleaning gas, the middle zone 30B is a zone of the process chamber 30 positioned on the midstream side in the flow direction of the cleaning gas, and the lower zone 30C is a zone of the process chamber 30 positioned on the upstream side in the flow direction of the cleaning gas. Here, the downstream side in the gas flow direction in the process chamber 30 means the side near the exhaust system configured to exhaust the internal atmosphere of the process chamber 30, and the upstream side in the gas flow direction means the side opposite the downstream side. Further, the midstream side in the gas flow direction means the side near the middle between the downstream side and the upstream side. That is, the upstream side, the midstream side, and the downstream side of the gas flow may not match positions of the zones of the heater 60, respectively.

As shown in FIG. 1, temperature sensors as temperature detectors configured to detect the internal temperature of the reaction tube 32 are installed in the tubular space 37. Specifically, a temperature sensor 62A is installed in the range of the tubular space 37 that is heated by the heater part 60A, a temperature sensor 62B is installed in the range of the tubular space 37 that is heated by the heater part 60B, and a temperature sensor 62C is installed in the range of the tubular space 37 that is heated by the heater part 60C.

The controller 70 is electrically connected to the heater part 60A, the heater part 60B, the heater part 60C, the temperature sensor 62A, the temperature sensor 62B, and the temperature sensor 62C. The controller 70 is configured to control supply of power to each heater part of the heater 60 at a desired timing based on the temperature information detected by each temperature sensor such that a temperature distribution in the process chamber 30 becomes a desired temperature distribution.

### (Controller)

The controller 70 is configured as a computer. The computer includes a CPU (Central Processing Unit) 121A, a RAM (Random Access Memory) 121B, a memory 73, and an I/O port 74, as shown in FIG. 4.

The RAM 72, the memory 73, and the I/O port 74 are configured to be capable of exchanging data with the CPU 71 via an internal bus 75. An input/output device 76 configured as, for example, a touch panel or the like is connected to the controller 70.

The memory 73 includes, for example, a flash memory, a HDD (Hard Disk Drive), or the like. A control program that controls operations of the substrate processing apparatus, a process recipe, etc. in which sequences and conditions of substrate processing to be described later are written, are readably stored in the memory 73.

The process recipe functions as a program combined to cause the controller 70 to execute each sequence in a substrate processing process to be described later to obtain an expected result. Hereinafter, the process recipe, the control program, and the like are generally and simply referred to as a program.

When the term "program" is used in the present disclosure, it may indicate a case of including the process recipe, a case of including the control program, or a case of including both the process recipe and the control program. The RAM 72 is configured as a memory area (work area) in which a program or data read by the CPU 71 is temporarily stored.

The I/O port 74 is connected to the valves 100 to 109, the MFCs (mass flow controllers) 110 to 119, the valves 120 to 129, the pressure sensor 142, the APC valve 143, the vacuum pump 144, the heater parts 60A to 60C of the heater 60, the temperature sensors 62A to 62C, the rotator (not shown), the boat elevator (not shown), and the like.

The CPU 71 is configured to read out and execute the control program from the memory 73 and read out the process recipe from the memory 73 in response to input or the like of an operation command from the input/output device 76.

The CPU 71 is configured to be capable of controlling the flow rate regulating operation of various gases by the MFCs 110 to 119, the opening/closing operation of the valves 100 to 109 and the valves 110 to 119, and the opening/closing operation of the APC valve 143 in accordance with contents of the read process recipe. Further, the CPU 71 is configured to be capable of controlling the pressure regulating operation by the APC valve 143 based on the pressure sensor 142, the start and stop of the vacuum pump 144, and the temperature regulating operation of the heater 60 (the heater parts 60A to 60C) based on the temperature sensors 62A to 62C. Further, the CPU 71 is configured to be capable of controlling the rotation and the rotation speed adjusting operation of the boat 148 by the boat rotator, the raising/lowering operation of the boat 148 by the boat elevator, and the like.

The controller 70 is not limited to being configured as a dedicated computer, and may be configured as a general-purpose computer. For example, the controller 70 of the embodiments of the present disclosure may be configured by providing an external memory 77 storing the above-described program and installing the program in a general-purpose computer by using the external memory 77. Examples of the external memory may include a magnetic disk such as a hard disk, an optical disc such as a CD, a magneto-optical disc such as a MO, a semiconductor memory such as a USB memory, and the like.

However, a configuration of supplying the program to the computer is not limited to a case of supplying the program via the external memory 77. For example, the program may be provided to the computer by using communication means or unit such as the Internet or a dedicated line, instead of using the external memory 77. The memory 73 or the external memory 77 is configured as a computer-readable recording medium. Hereinafter, the memory 73 and the external memory 77 may be generally and simply referred to as a recording medium. When the term "recording medium" is used in the present disclosure, it may indicate a case of including the memory 73, a case of including the external memory 77, or a case of including both the memory 73 and the external memory 77.

Further, the controller 70 according to the embodiments of the present disclosure is configured to be capable of controlling the heater parts 60A to 60C of the heater 60 so as to heat the inside of the process chamber 30 such that, in the process chamber 30, a temperature difference (T2) between the zone (the lower zone 30C) positioned on the upstream side in the gas flow direction and the zone (the middle zone 30B) adjacent to the zone positioned on the upstream side is greater than a temperature difference (T1) between the zone (the upper zone 30A) positioned on the downstream side in the gas flow direction and the zone (the middle zone 30B) adjacent to the zone positioned on the downstream side. Then, the controller 70 is configured to be capable of controlling the cleaning gas supply system 50 to supply the cleaning gas into the process chamber 30 while maintaining the temperature state of the heated inside of the process chamber 30 (the temperature state of T2>T1).

### <Substrate Processing Process>

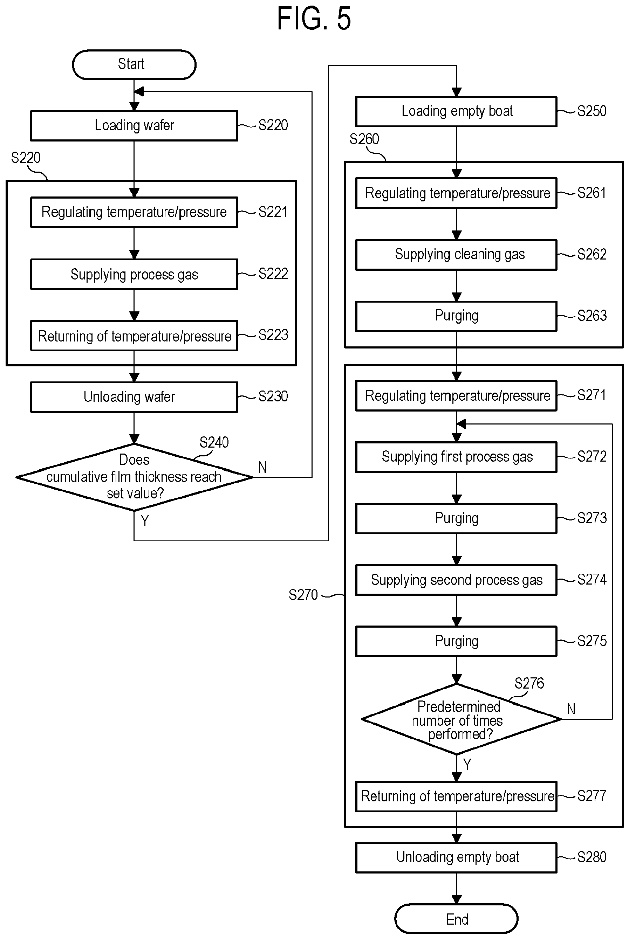

Next, as a process of manufacturing a semiconductor device, a substrate processing process in which a film-forming step of forming a film on the wafer 200, a cleaning step as a removing step of removing a film-forming material adhered to the inner surface of the process chamber 30, and a pre-coating step of forming a film with a predetermined thickness on the inner surface of the process chamber 30 are sequentially performed will be described with reference to FIG. 5. In the following description, operations of the respective components constituting the substrate processing apparatus 10 is controlled by the controller 70.

### (Loading Step)

In a loading step S210, the wafer 200 is loaded into the process chamber 30. Specifically, first, a plurality of wafers 200 are charged into the boat 148 (wafer charging). Then, as shown in FIG. 1, the boat 148 holding the plurality of wafers 200 is lifted by the boat elevator (not shown) and loaded into the process chamber 30 (boat loading). In this state, the seal cap 146 seals the lower end of the manifold 38 via the O-ring (not shown).

When performing the loading step S210, the inside of the process chamber 30 is purged by supplying an inert gas (a nitrogen gas in the embodiments) into the process chamber 30. Specifically, a flow rate of the inert gas supplied from the inert gas supply source 133 to the gas supply pipe 98 by opening the valves 108 and 128 is controlled by the MFC 118 to be a predetermined flow rate, and then the inert gas is supplied from the nozzle 82 into the process chamber 30 via the gas supply pipe 98. Further, a flow rate of the inert gas supplied from the inert gas supply source 133 to the gas supply pipe 99 by opening the valves 109 and 129 is controlled by the MFC 119 to be a predetermined flow rate, and then the inert gas is supplied from the nozzle 83 into the process chamber 30 via the gas supply pipe 99. In this way, the inert gas is supplied into the process chamber 30 to purge the inside of the process chamber 30. The supply of the inert gas into the process chamber 30 is continued until the entirety of steps of the substrate processing process are completed.

### (Film-Forming Step)

In a film-forming step S220, the inside of the process chamber is heated, and a film-forming process of forming a film on the wafer 200 is performed by supplying a process gas into the process chamber 30. Specifically, first, the inside of the process chamber 30 is vacuum-exhausted by the vacuum pump 144 to reach a predetermined film-forming pressure (degree of vacuum). At this time, the internal pressure of the process chamber 30 is measured by the pressure sensor 142, and the APC valve 143 is feedback-controlled based on the measured pressure information. Further, the inside of the process chamber 30 is heated by the heater 60 to reach a predetermined temperature. At this time, the supply of power to the heater parts 60A to 60C of the heater 60 is feedback-controlled based on the temperature information detected by the temperature sensors 62A to 62C such that the internal temperature of the process chamber 30 becomes a predetermined temperature (film-forming temperature) (S221). Subsequently, the rotation of the boat 148 and the wafer 200 is started by the rotator (not shown).

With the inside of the process chamber 30 maintained at the predetermined film-forming temperature and the predetermined film-forming pressure, the supply of a first process gas and a second process gas into the process chamber 30 is started (S222). Specifically, a flow rate of the first process gas supplied from the first process gas supply source 130 into the gas supply pipe 90 by opening the valves 100 and 120 is controlled by the MFC 110 to be a predetermined flow rate, and then the first process gas is supplied from the nozzle 80 into the process chamber 30 via the gas supply pipe 90. Further, a flow rate of the first process gas supplied from the first process gas supply source 130 into the gas supply pipe 91 by opening the valves 101 and 121 is controlled by the MFC 111 to be a predetermined flow rate, and then the first process gas is supplied from the nozzle 81 into the process chamber 30 via the gas supply pipe 91. In this way, the first gas is supplied into the process chamber 30. On the other hand, a flow rate of the second process gas supplied from the second process gas supply source 131 into the gas supply pipe 92 by opening the valves 102 and 122 is controlled by the MFC 112 to be a predetermined flow rate, and then the second process gas is supplied from the nozzle 82 into the process chamber 30 via the supply pipe 92. Further, a flow rate of the second process gas supplied from the second process gas supply source 131 into the gas supply pipe 93 by opening the valves 103 and 123 is controlled by the MFC 113 to be a predetermined flow rate, and then the second process gas is supplied from the nozzle 83 into the process chamber 30 via the gas supply pipe 93.

At this time, an inert gas supplied into the process chamber 30 functions as a dilution gas that dilutes the film-forming gas (the first process gas and the second process gas) or as a carrier gas that promotes diffusion into the process chamber 30. By controlling a supply flow rate of the inert gas, it is possible to control a concentration and a diffusion rate of the film-forming gas (the first process gas and the second process gas).

The film-forming gas (the first process gas and the second process gas) supplied into the process chamber 30 rises inside the inner pipe 34 (inside the process chamber 30) and flows out from the upper end opening of the inner pipe 34 into the tubular space 37. Then, after flowing down the tubular space 37, the film-forming gas is discharged from the exhaust pipe 141. The film-forming gas contacts the surface of the wafer 200 while passing through the process chamber 30. At this time, a thin film is deposited on the surface of the wafer 200 by thermal CVD reaction. With a lapse of a predetermined processing time, when a thin film with a predetermined thickness is formed on the wafer 200, the valves 100 to 103 and the valves 120 to 123 are respectively closed to stop the supply of the film-forming gas into the process chamber 30.

Then, with the valves 108 and 128 and the valves 109 and 129 kept open, while the supply of the inert gas into the process chamber 30 is continued, the inside of the process chamber 30 is exhausted to purge the inside of the process chamber 30. After the internal atmosphere of the process chamber 30 is substituted with the inert gas, an opening state of the APC valve 143 is regulated to return the internal pressure of the process chamber 30 to the normal pressure. Further, the supply of electrical power to the heater 60 is stopped to lower the internal temperature of the process chamber 30 to a predetermined temperature (wafer unloading temperature) (S223).

A process condition in the film-forming step S220 according to the embodiments of the present disclosure is exemplified as follows:
Film-forming temperature: 600 degrees C to 850 degrees C (specifically around 650 degrees C to 800 degrees C),
First process gas supply flow rate: 10 sccm to 2,000 sccm (specifically 50 sccm to 200 sccm),
Second process gas supply flow rate: 100 sccm to 10,000 sccm (specifically 500 sccm to 2,000 sccm), and
Film-forming pressure: 1 Pa to 2,666 Pa (specifically, less than 133 Pa).

A film (silicon nitride film) with a thickness of, for example, 10 nm to 200 nm is formed on the wafer 200 by keeping each process condition constant at a certain value within each range.

A silicon-containing gas or the like may be used as the first process gas. Examples of the silicon-containing gas may include a dichlorosilane (SiH₂Cl₂, abbreviation: DCS) gas.

A nitrogen-containing gas or the like may be used as the second process gas. Examples of the nitrogen-containing gas may include an ammonia (NH₃) gas.

### (Unloading Step)

In an unloading step S230, the processed wafer 200 is unloaded from the process chamber 30. Specifically, after the wafer 200 is subjected to the film-forming process, the rotation of the boat 148 and the wafer 200 by the rotator is stopped. Next, the seal cap 146 is lowered by the boat elevator to open the lower end of the manifold 38, and the boat 148 holding the processed wafer 200 is unloaded out of the reaction tube 32 (boat unloading). Thereafter, the processed wafer 200 is discharged from the boat 148 (wafer discharging).

In the film-forming step S220, the film (silicon nitride film) is formed on the wafer 200 by the film-forming gas, but a film is also formed on the inner surface of the inner tube 34 (in other words, the inner surface of the process chamber 30) by this film-forming gas. That is, a film-forming material adheres to the inner surface of the process chamber 30. Therefore, when the film-forming step is repeated, a thickness of a deposit (film-forming material) adhered to the inner surface of the process chamber 30 increases. Here, when the thickness of the deposit reaches a predetermined thickness, a cleaning step S260, which will be described later, is performed. Specifically, the film thickness that increases each time the film-forming step is performed is obtained in advance, and it is determined whether or not the film thickness (cumulative film thickness) after performing the film-forming step a plurality of times reached a predetermined thickness (S240). In S240, when it is determined that the film thickness after performing the film-forming step a plurality of times reached the predetermined thickness, the cleaning step S260 is performed.

### (Empty Boat Loading Step)

In an empty boat loading step S250, an empty boat 148 not charged with the wafer 200, that is, the boat 148 charged with no wafer 200, is lifted by the boat elevator and loaded into the process chamber 30 (boat loading). In this state, the seal cap 146 seals the lower end of the manifold 38 via the O-ring. The empty boat 148 may be charged with a dummy wafer (not shown) instead of a product wafer.

### (Cleaning Step)

In the cleaning step S260, the inside of the process chamber 30 to which a cleaning gas is supplied is divided into three or more zones in the gas flow direction of the cleaning gas, the inside of the process chamber 30 is heated such that, in the process chamber 30, the temperature difference (T2) between the lower zone 30C positioned on the upstream side in the gas flow direction and the middle zone 30B adjacent to the lower zone 30C is greater than the temperature difference (T1) between the upper zone 30A positioned on the downstream side in the gas flow direction and the middle zone 30B adjacent to the upper zone 30A, and while maintaining the temperature state of the heated inside of the process chamber 30, the cleaning gas is supplied into the process chamber 30 to remove the deposit containing the film-forming material adhered to the inner surface of the process chamber 30. Specifically, first, the inside of the process chamber 30 is vacuum-exhausted by the vacuum pump 144 such that the inside of the process chamber 30 reaches a predetermined cleaning pressure (state of vacuum), and the inside of the process chamber 30 is heated by the heater 60 such that the inside of the process chamber 30 reaches a predetermined cleaning temperature (S261). Further, S261 is an example of a heating step of the present disclosure.

Here, a method of heating the inside of the process chamber 30 by the heater 60 will be described in detail. First, the inside of the process chamber 30 is divided into three zones in the gas flow direction of the cleaning gas, and the inside of the process chamber 30 is heated such that, in the process chamber 30, the temperature difference (T2) between the lower zone 30C and the middle zone 30B is greater than the temperature difference (T1) between the upper zone 30A and the middle zone 30B. Specifically, the heat generation temperature of the heater part 60A of the heater 60 corresponding to the upper zone 30A, the heat generation temperature of the heater part 60B of the heater 60 corresponding to the middle zone 30B, and the heat generation temperature of the heater part 60C of the heater 60 corresponding to the lower zone 30C are regulated, and the process chamber 30 is heated such that the temperature difference (T2) is greater than the temperature difference (T1). The temperature difference (T2) may be set to 5 to 50 times the temperature difference (T1). Further, when heating the process chamber 30, the inside of the process chamber 30 may be heated such that, in the process chamber 30, the temperature of the lower zone 30C is lower than the temperature of the upper zone 30A. Further, when heating the process chamber 30, the inside of the process chamber 30 may be heated such that, in the process chamber 30, the temperature of the lower zone 30C is lower than the temperature of the middle zone 30B. That is, the inside of the process chamber 30 is heated such that, in the process chamber 30, the temperature of the zone positioned on the upstream side in the gas flow direction is lower than the temperature of the zone positioned on the downstream side in the gas flow direction. Further, the inside of the process chamber 30 may be heated such that, in the process chamber 30, the temperature of the zone positioned on the upstream side in the gas flow direction is lower than the temperature of the zone positioned on the midstream side in the gas flow direction.

Subsequently, the rotation of the boat 148 by the rotator is started. In the present disclosure, the boat 148 may not be rotated.

Next, while maintaining the temperature state of the heated inside of the process chamber 30 (the state where the temperature difference (T2) is greater than the temperature difference (T1)), the cleaning gas is supplied into the process chamber 30 to remove the deposit containing the film-forming material adhered to the inner surface of the process chamber 30. Specifically, while maintaining the inside of the process chamber 30 at a predetermined cleaning temperature and a predetermined cleaning pressure, the supply of the cleaning gas into the process chamber 30 is started. Flow rates of the cleaning gas supplied from the cleaning gas supply source 132 into the gas supply pipe 90 and the gas supply pipe 91 by opening the valves 104 and 124 and the valves 105 and 125, respectively, are controlled by the MFC 114 and the MFC 115, respectively, so as to be predetermined flow rates, and then the cleaning gases are supplied from the nozzle 80 and the nozzle 81 into the process chamber 30 via the gas supply pipe 94 and the gas supply pipe 91, respectively. At the same time, flow rates of the cleaning gases supplied from the cleaning gas supply source 132 into the gas supply pipe 96 and the gas supply pipe 97 by opening the valves 106 and 126 and the valves 107 and 127, respectively, are controlled by the MFC 116 and the MFC 117, respectively, so as to be predetermined flow rates, and then the cleaning gases are supplied from the nozzle 82 and the nozzle 83 into the process chamber 30 via the gas supply pipe 96 and the gas supply pipe 97, respectively (S262). Further, S262 is an example of a supplying step of the present disclosure.

A supply amount of the cleaning gas may be controlled such that, in the process chamber 30, an etching rate (etching speed) of the deposit adhered to the inner surface of the process chamber 30 becomes lower on the upstream side in the gas flow direction (in other words, on the lower side (the lower zone 30C) of the process chamber 30) than on the downstream side in the gas flow direction (in other words, the upper side (the upper zone 30A) of the process chamber 30). Specifically, by regulating a ratio of cleaning gas supplies of the nozzle 81 and the nozzle 83 configured to supply the cleaning gas into the process chamber 30 on the midstream side (in other words, on the middle side (the middle zone 30B) of the process chamber 30) or the upstream side in the gas flow direction of the process chamber 30 to the nozzle 80 and the nozzle 82 configured to supply the cleaning gas into the process chamber 30 on the upstream side in the gas flow direction, it is possible to make the etching rate of the deposit lower on the lower side of the process chamber 30 than on the upper side of the process chamber 30. Further, the supply amount of the cleaning gas may be set such that the etching rate of the deposit on the upper side of the process chamber 30 is substantially the same as that on the middle side of the process chamber 30.

At this time, an inert gas supplied into the process chamber 30 functions as a dilution gas that dilutes the cleaning gas or as a carrier gas that promotes diffusion into the process chamber 30. By controlling the supply flow rate of the inert gas, a concentration and a diffusion rate of the cleaning gas can be controlled.

The cleaning gas supplied into the process chamber 30 rises inside the inner pipe 34 (inside the process chamber 30 ), flows out from the upper end opening of the inner pipe 34 into the tubular space 37, flows down the tubular space 37, and then is discharged from the exhaust pipe 141. When the cleaning gas passes through the process chamber 30, it comes into contact with the deposit accumulated in the process chamber 30 (a nitride film or the like in the embodiments. Here, the nitride film is, for example, a silicon nitride film or the like) to remove the deposit by thermochemical reaction. That is, the heated and activated cleaning gas serves as etching species, which etch and removes the silicon nitride film and the like as the deposit accumulated in the process chamber 30. Further, in the embodiments, the nozzles 80 to 84 configured to supply the film-forming gas into the process chamber 30 are used as the nozzles configured to supply the cleaning gas into the process chamber 30. According to this configuration, the silicon nitride film adhered inside the nozzles 80 to 84 may also be removed efficiently. With a lapse of a preset processing time, when the removal of the silicon nitride film and the like is completed, the valves 104 to 107 and the valves 124 to 127 are closed to stop the supply of the cleaning gas into the process chamber 30.

Then, with the valve 108 and the valve 128 and the valve 109 and the valve 129 kept open, while the supply of the inert gas into the process chamber 30 is continued, the inside of the process chamber 30 is exhausted to purge the inside of the process chamber 30 (S263).

A process condition in the cleaning step S260 according to the embodiments of the present disclosure is exemplified as follows:
Cleaning temperature: 300 degrees C to 500 degrees C (specifically, around 350 degrees C to 450 degrees C);
Cleaning gas supply flow rate: 1 sccm to 20,000 sccm (specifically, 1 sccm to 10,000 sccm); and
Cleaning pressure: 1 Pa to 60,000 Pa (specifically, 5,000 Pa to 20,000 Pa).

As the cleaning gas, a gas containing a halogen element, specifically a gas containing a fluorine element may be used. Examples of the gas containing the fluorine element may include F₂, HF, NF₃, and CF₄. The cleaning gas may contain at least one selected from the group of F₂, HF, NF₃, and CF₄. In the present disclosure, an example where a NF₃ gas is used is described.

### (Pre-Coating Step)

In a pre-coating step S270, the inside of the process chamber 30 is heated, and a process gas is supplied into the process chamber 30 to perform a pre-coating process of forming a film on the inner surface of the process chamber 30. Specifically, immediately after the cleaning step S260 is completed, with the empty boat 148 not charged with the wafer 200 being loaded into the process chamber 30 (boat loading), the inside of the process chamber 30 is vacuum-exhausted by the vacuum pump 144 to reach a predetermined pre-coating pressure (state of vacuum), and the inside of the process chamber 30 is heated by the heater 60 to reach a predetermined cleaning temperature (S271). Subsequently, the rotation of the boat 148 by the rotator is started. Further, a pre-coating temperature may be set lower than the film-forming temperature in the film-forming step S220.

Then, the supply of the first process gas into the process chamber 30 is started (S272). Flow rates of the first process gas supplied from the first process gas supply source 130 into the gas supply pipes 90 and 91 by opening the valves 100 and 120 and the valves 101 and 121 are controlled by the MFCs 110 and 111, respectively, so as to be predetermined flow rates, and then the first process gases are supplied from the nozzles 80 and 81 into the process chamber 30. At this time, an inert gas supplied into the process chamber 30 functions as a dilution gas that dilutes the first process gas or as a carrier gas that promotes diffusion into the process chamber 30.

The first process gas supplied into the process chamber 30 rises inside the inner pipe 34 (inside the process chamber 30 ), flows out from the upper end opening of the inner pipe 34 into the tubular space 37, flows down the tubular space 37, and then is discharged from the exhaust pipe 141. When the first process gas passes through the process chamber 30, it comes into contact with the inner wall of the process chamber 30, the surface of the boat 148, and the like. At this time, when a DCS gas is used as the first process gas, a silicon layer (Si layer), which is a silicon-containing layer of less than one atomic layer to several atomic layers, is formed on these surfaces. At this time, a maximum internal pressure of the process chamber 30 when supplying the first process gas may be higher than a maximum internal pressure of the process chamber 30 in the film-forming step S220. With a lapse of a preset processing time, when the formation of the silicon layer is completed, the valves 100 and 120 and the valves 101 and 121 are closed to stop the supply of the first process gas into the process chamber 30.

Then, with the valves 108 and 128 and the valves 109 and 129 kept open, while the supply of the inert gas into the process chamber 30 is continued, the inside of the process chamber 30 is exhausted to purge the inside of the process chamber 30 (S273).

Then, the supply of the second process gas into the process chamber 30 is started (S274). Flow rates of the second process gases supplied from the second process gas supply source 131 into the gas supply pipes 92 and 93 by opening the valves 102 and 122 and the valves 103 and 123 are controlled by the MFCs 112 and 113, respectively, so as to be predetermined flow rates, and then is the second process gases are supplied from the nozzles 82 and 83 into the process chamber 30. At this time, an inert gas supplied into the process chamber 30 functions as a dilution gas that dilutes the second process gas or as a carrier gas that promotes diffusion into the process chamber 30.

The second process gas supplied into the process chamber 30 rises inside the inner pipe 34 (inside the process chamber 30 ), flows out from the upper end opening of the inner pipe 34 into the tubular space 37, flows down the tubular space 37, and then is discharged via the exhaust pipe 141. When the second process gas passes through the process chamber 30, it comes into contact with the silicon layer formed on the inner surface of the process chamber 30 and the surface of the boat 148. When a NH₃ gas is used as the second process gas, the silicon layer is nitrided to form a silicon nitride layer (SiN layer) of less than one atomic layer to several atomic layers. At this time, a maximum internal pressure of the process chamber 30 when supplying the second process gas may be higher than a maximum internal pressure of the process chamber 30 in the film-forming step S220. With a lapse of a preset processing time, when the formation of the silicon nitride layer is completed, the valves 102 and 122 and the valves 103 and 123 are closed to stop the supply of the second process gas into the process chamber 30.

Then, with the valves 108 and 128 and the valves 109 and 129 kept open, while the supply of the inert gas into the process chamber 30 is continued, the inside of the process chamber 30 is exhausted to purge the inside of the process chamber 30 (S275).

By performing a cycle including the above-described S272 to S275 one or more times, a silicon nitride film (pre-coating film) with a predetermined thickness is formed on the inner surface of the process chamber 30 and the surface of the boat 148 (S276). The above-described cycle may be performed a plurality of times. In a case where a silicon-containing gas is used as the first process gas and a nitrogen-containing gas is used as the second process gas, the supply amounts of the first process gas and the second process gas may be regulated such that a content of silicon (Si) contained in the pre-coating film becomes equal to or higher than a content of silicon (Si) contained in the silicon nitride film formed on the wafer 200 in the film-forming step S220.

A process condition in the pre-coating step S270 according to the embodiments of the present disclosure is exemplified as follows:
Pre-coating temperature: 600 degrees C to 850 degrees C (specifically, around 650 degrees C to 800 degrees C);
First process gas supply flow rate: 10 sccm to 2,000 sccm (specifically, 50 sccm to 200 sccm);
Second process gas supply flow rate: 100 sccm to 10,000 sccm (specifically, 500 sccm to 2,000 sccm); and
Film-forming pressure: 1 Pa to 2,666 Pa (specifically, less than 133 Pa).

By maintaining each process condition at a certain value within each range, a silicon nitride film (pre-coating film) with a thickness of, for example, 10 to 100 nm is formed on the inner surface of the process chamber 30 and the surface of the boat 148.

After performing the above-described cycle a predetermined number of times to form a silicon nitride film (pre-coating film) with a predetermined film thickness, with the valves 108 and 128 and the valves 109 and 129 kept open, while the supply of the inert gas into the process chamber 30 is continued, the inside of the process chamber 30 is exhausted to purge the inside of the process chamber 30. After the inside of the process chamber 30 is substituted with the inert gas, an opening state of the APC valve 143 is regulated to return the internal pressure of the process chamber 30 to the normal pressure. Further, the supply of electric power to the heater 60 is stopped to lower the internal temperature of the process chamber 30 to a predetermined temperature (boat unloading temperature) (S277).

Although the example of forming the pro-coating film by cyclic processing is shown herein, the present disclosure is not limited thereto. The pre-coating film may be formed by a CVD film-forming process with a timing at which the first process gas and the second process gas are supplied simultaneously.

### (Empty Boat Unloading Step)

In an empty boat unloading step S280, the empty boat is unloaded out of the reaction tube 32. Specifically, after the pre-coating step S270 is completed, the rotation of the boat 148 by the rotator is stopped, the seal cap 146 is lowered by the boat elevator to open the lower end of the manifold 38, and the empty boat 148 is unloaded from the lower end of the manifold 38 out of the reaction tube 32 (boat unloading). After that, the above-described loading step S210 and film-forming step S220 are sequentially performed.

### <Program>

A program according to some embodiments of the present disclosure is a program that causes a controller (70) as a computer to perform a process including:
dividing an inside of a process chamber (30), into which a cleaning gas is to be supplied, into three or more zones in a gas flow direction and heating the inside of the process chamber (30) such that, in the process chamber, a temperature difference (T2) between a zone (lower zone (30C)) positioned on an upstream side in the gas flow direction and a zone (middle zone (30B)) adjacent to the zone positioned on the upstream side is greater than a temperature difference (T1) between a zone (upper zone (30A)) positioned on a downstream side in the gas flow direction and a zone (middle zone (30B)) adjacent to the zone positioned on the downstream side; and
supplying the cleaning gas into the process chamber (30) while maintaining a temperature state of the inside of the process chamber (30) heated in the act of heating.

Next, operations and effects of the embodiments of the present disclosure will be described. In the film-forming process immediately after cleaning, a phenomenon in which the thickness (film thickness) of the film formed on the wafer 200 is reduced (so-called film thickness drop phenomenon) occurs. This is caused by residual fluorine (F) of the fluorine-containing gas used when performing the cleaning in the process chamber 30. Specifically, the cleaning gas reacts with the deposit adhered to the inner surface of the process chamber 30, and components of the cleaning gas are discharged to the outside of the reaction tube 32 together with components of the deposit. Inside the reaction tube 32, there are a thick portion and a thin portion of the deposit, and the supply amount of the cleaning gas is regulated according to the thick portion. For this reason, at the thin portion of the deposit, during cleaning, the deposit disappears and the components of the cleaning gas remain adsorbed without being discharged, or the components of the cleaning gas react with the surface of a member (for example, the boat 148) disposed in the reaction tube 32 and the components of the cleaning gas may remain on the surface of the member disposed in the reaction tube 32. Fluorine, which is the component of the cleaning gas remaining in the reaction tube 32 in this manner, reacts with the film-forming gas (for example, at least one selected from the group of DCS gas and NH₃ gas) used during processing (film-forming processing) on the wafer 200. This reduces an amount of film-forming gas reaching the wafer 200. As a result, the thickness of the film formed on the wafer 200 is reduced. This phenomenon of reducing the film thickness appears remarkably when the film-forming gas is supplied from the lower side to the upper side of the reaction tube 32. Therefore, in the market, there is a demand for production processing that suppresses occurrence of the film thickness drop phenomenon on the wafer 200 in the film-forming process immediately after cleaning. In other words, there is a demand for uniformity of processing for each wafer 200. Therefore, in the cleaning step of the embodiments of the present disclosure, the inside of the process chamber 30 is divided into three or more zones in the gas flow direction, the inside of the process chamber 30 is heated such that, in the process chamber 30, the temperature difference (T2) between the lower zone 30C and the adjacent middle zone 30B is greater than the temperature difference (T1) between the upper zone 30A and the adjacent middle zone 30B, and the cleaning gas is supplied into the process chamber 30 while maintaining the temperature state. As a result, a cleaning rate (cleaning amount) in the lower zone 30C in the process chamber 30 becomes slower than a cleaning rate (cleaning amount) in each of the upper zone 30A and middle zone 30B. That is, by lowering the temperature of the lower zone 30C of the process chamber 30, it is possible to reduce an amount of consumption (reaction amount, decomposition amount, and the like) of the cleaning gas in the lower zone 30C. As a result, it is possible to reduce an amount of fluorine element generated in the lower zone 30C of the process chamber 30 to suppress the residue of fluorine element after cleaning. Further, by setting the aforementioned temperature condition (T2>T1), it is possible to stably supply an unreacted cleaning gas to the middle zone 30B and the upper zone 30A in the process chamber 30 as well. As a result, cleaning uniformity in the gas flow direction of the process chamber 30 is improved. As a result, film-forming inhibition factors for the next film-forming process may be reduced, such that the occurrence of the film thickness drop phenomenon on the wafer 200 may be suppressed even immediately after cleaning. In other words, the film thickness of the wafer 200 may be stabilized. Therefore, the processing one each wafer 200 may be made substantially uniform.

By using a halogen-based gas as the cleaning gas, it is possible to shorten a cleaning time for the deposit adhered to the inner surface of the process chamber 30.

Further, by using a fluorine-containing gas, specifically a gas containing at least one selected from the group of F₂, HF, NF₃, and CF₄, as the cleaning gas, it is possible to shorten a cleaning time for a film containing Si and N (silicon nitride film).

In the embodiments of the present disclosure, the nozzles 80 and 82 are configured to be capable of supplying the cleaning gas into the process chamber 30 from the lower zone 30C toward the upper zone 30A of the process chamber 30. Therefore, it is possible to clean the process chamber 30 from upstream to downstream in the gas flow direction. In other words, it is possible to clean the process chamber 30 from the lower side to the upper side.

In the embodiments of the present disclosure, the nozzles 81 and 83 are configured to be capable of supplying the cleaning gas into the process chamber 30 in the middle zone 30B (midstream side) and the upper zone 30A (downstream side) of the process chamber 30. Therefore, an unreacted cleaning gas may be reliably supplied to the middle zone 30B and the upper zone 30A. As a result, it is possible to clean the process chamber 30 substantially uniformly from the upstream side to the downstream side in the gas flow direction. Further, it is possible to improve a controllability of a cleaning atmosphere (condition) in the process chamber 30 from the upstream side to the downstream side in the gas flow direction and to suppress residue of F from the upstream side to the downstream side in the gas flow direction.

Further, in the pre-coating step of the embodiments, the pre-coating process is performed under a condition of forming the silicon nitride film with a silicon content, which is higher than a silicon content of the silicon nitride film formed by the film-forming process. Specifically, a condition is set such that a supply ratio of the first process gas to the second process gas in the pre-coating process is higher than a supply ratio of the first process gas to the second process gas in the film-forming process. Here, the supply ratio is a ratio of supplies of the first process gas and the second process gas, and includes at least one or more selected from the group of a gas supply flow rate and a supply time. For example, the supply flow rate of the first process gas in the pre-coating process is set to be higher than the supply flow rate of the first process gas in the film-forming process. By supplying the first process gas and the second process gas in this manner, it is possible to remove fluorine remaining in the reaction tube 32 and to suppress reduction in film thickness during the film-forming process. Further, the first process gas used in the pre-coating process may be the same gas as the first process gas used in the film-forming process, or may be a gas with a different molecular structure.

Further, in the pre-coating step of the embodiments of the present disclosure, since the pre-coating process is performed at a lower pressure than the film-forming process, a exposure amount (contact time) between the first process gas and the residual F may be increased. Thus, the residual F reacts with DCS and is discharged. As a result, it is possible to reduce F remaining in the process chamber 30 and to improve the film thickness drop rate. On the other hand, in the film-forming process, by setting the pressure higher than that in the pre-coating process, it is possible to reduce the exposure amount (contact time) between the first process gas and the residual F and, even in a case where F remains, it is possible to suppress the occurrence of the film thickness drop phenomenon during wafer processing.

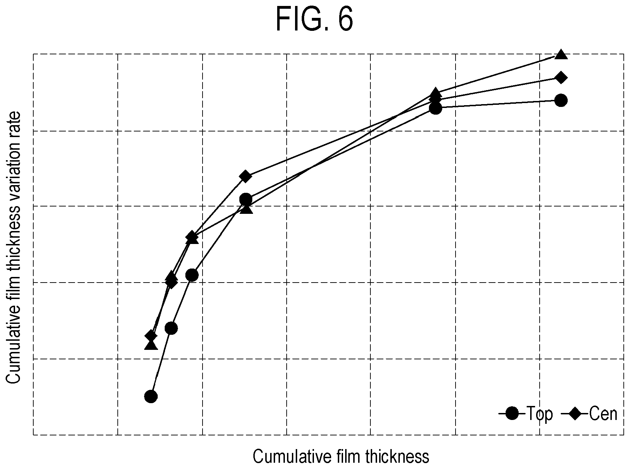

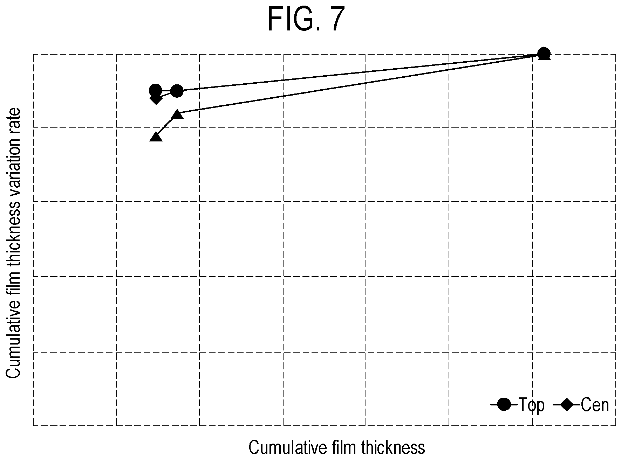

FIG. 6 shows a graph showing a relationship between a cumulative film thickness (accumulated deposit thickness) and a film thickness variation rate of each zone 30A to 30C in the process chamber 30 when a cleaning method of a comparative example is carried out. In the cleaning method of this comparative example, the temperatures of the zones 30A to 30C are the same. FIG. 7 also shows a graph showing a relationship between a cumulative film thickness and a film thickness variation rate of each zone 30A to 30C in the process chamber 30 when a cleaning method of an example is carried out. In the cleaning method shown in FIG. 7, since the temperature of each zone 30A to 30C is controlled such that the temperature difference (T2) > the temperature difference (T1), the film thickness variation rate of each zone 30A to 30C with respect to the cumulative film thickness in the process chamber 30 is small. That is, in the cleaning method of the example, it may be seen that the process chamber 30 may be uniformly cleaned from the upstream to the downstream in the gas flow direction and, further, residue of F on the upstream side in the gas flow direction is suppressed.

In the above-described embodiments of the present disclosure, the example in which the DCS gas is used as the first process gas are described, but the present disclosure is not limited thereto. Examples of the first process gas (precursor gas) may include chlorosilane gases such as a monochlorosilane (SiH₃Cl, abbreviation: MCS) gas, a trichlorosilane (SiHCl₃, abbreviation: TCS) gas, a tetrachlorosilane (SiCl₄, abbreviation: STC) gas, a hexachlorodisilane gas (Si₂Cl₆, abbreviation: HCDS) gas, and an octachlorotrisilane (Si₃Cl₈, abbreviation: OCTS) gas. One or more selected from the group of these gases may be used as the precursor gas.

Further, in addition to the chlorosilane gases, examples of the precursor gas may include fluorosilane gases such as a tetrafluorosilane (SiF₄) gas and a difluorosilane (SiH₂F₂) gas, bromosilane gases such as a tetrabromosilane (SiBr4) gas and a dibromosilane (SiH₂Br₂) gas, and iodosilane gases such as a tetraiodosilane (SiI₄) gas and a diiodosilane (SiH₂I₂) gas. One or more selected from the group of these gases may be used as the precursor gas.

Further, in addition to these gases, for example, a gas containing Si and an amino group, that is, an aminosilane gas, may also be used as the precursor gas. The amino group is a monovalent functional group obtained by removing hydrogen (H) from ammonia, a primary amine or a secondary amine, and may be expressed as -NH₂, -NHR, or -NR₂. Further, R represents an alkyl group, and the two R's in -NR₂ may be the same or different.

Examples of the precursor gas may also include aminosilane gases such as a tetrakis(dimethylamino)silane (Si[N(CH₃)₂]₄, abbreviation: 4DMAS) gas, a tris(dimethylamino)silane (Si[N(CH₃)₂]₃H, abbreviation: 3DMAS) gas, a bis(diethylamino)silane (Si[N(C₂H₅)₂]₂H₂, abbreviation: BDEAS) gas, a bis(tert-butylamino)silane (SiH₂[NH(C₄H₉)]₂, abbreviation: BTBAS) gas, and a (diisopropylamino)silane (SiH₃[N(C₃H₇)₂], abbreviation: DIPAS) gas. One or more selected from the group of these gases may be used as the precursor gas.

In the above-described embodiments, the example in which the NH₃ gas is used as the second process gas is described, but the present disclosure is not limited thereto. Examples of the second process gas (reaction gas) may include hydrogen nitride-based gases such as a diazene (N₂H₂) gas, a hydrazine (N₂H₄) gas, and a N₃H₈ gas. One or more selected from the group of these gases may be used as the reaction gas.

Further, in addition to these gases, for example, a nitrogen (N)-, carbon (C)-, and hydrogen (H)-containing gas may also be used as the reaction gases. For example, an aminebased gas or an organic hydrazine-based gas may be used as the N-, C-, and H-containing gas. The N-, C-, and H-containing gas is a N-containing gas, a C-containing gas, a H-containing gas, and a N- and C-containing gas.

Further, examples of the reaction gas may include ethylamine-based gases such as a monoethylamine (C₂H₅NH₂, abbreviation: MEA) gas, a diethylamine ((C₂H₅)₂NH, abbreviation: DEA) gas, and a triethylamine ((C₂H₅)₃N, abbreviation: TEA ) gas, methylamine-based gases such as a monomethylamine (CH₃NH₂, abbreviation: MMA) gas, a dimethylamine ((CH₃)₂NH, abbreviation: DMA) gas, and a trimethylamine ((CH₃)₃N, abbreviation: TMA) gas, organic hydrazine-based gases such as a monomethylhydrazine ((CH₃)HN₂H₂, abbreviation: MMH) gas, a dimethylhydrazine ((CH₃)₂N₂H₂, abbreviation: DMH) gas, and a trimethylhydrazine ((CH₃)₂N₂(CH₃)H, abbreviation: TMH) gas, and the like. One or more selected from the group of these gases may be used as the reaction gas.

In the above-described embodiments of the present disclosure, the example in which a film is formed by using a substrate processing apparatus that is a batch-type vertical apparatus configured to process a plurality of substrates at a time is described, but the present disclosure is not limited thereto and may also be suitably applied to a case where a film is formed by using a single-wafer type substrate processing apparatus configured to process a single substrate or several substrates at a time.

Further, in the above-described embodiments, the inert gas is supplied into the process chamber 30 during the substrate processing process, but the present disclosure is not limited to such a configuration. For example, the controller 70 may appropriately regulate the supply amount of the inert gas when purging the inside of the process chamber 30 or diluting a gas.

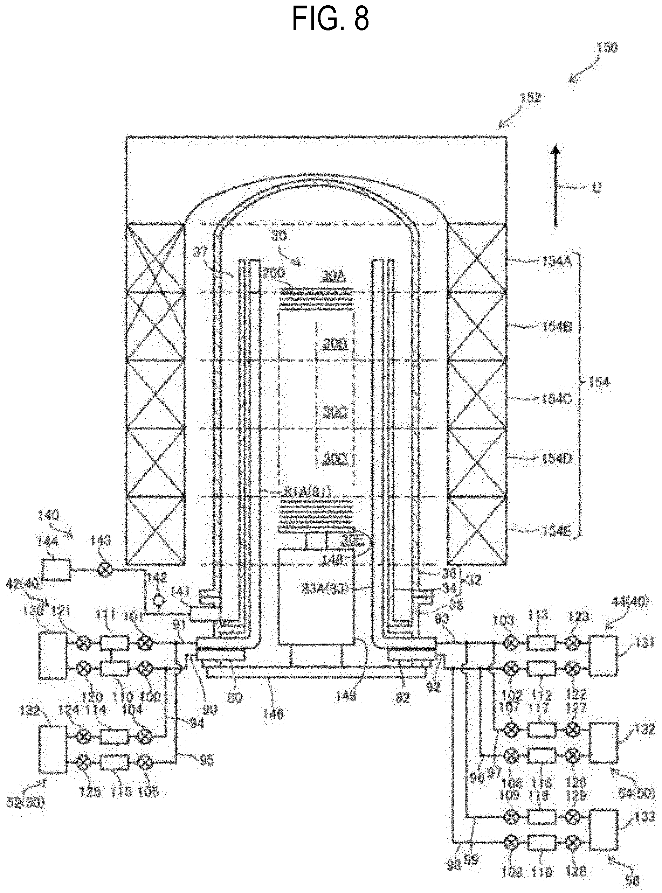

Furthermore, in the above-described embodiments, the inside of the process chamber 30 is divided into three zones, but the present disclosure is not limited to such a configuration. The inside of the process chamber 30 may be divided into three or more zones. For example, FIG. 8 shows a substrate processing apparatus 150 in which the inside of the process chamber 30 is divided into five zones. In this substrate processing apparatus 150, a heater 154 installed at a process furnace 152 includes five heater parts 154A to 154E, and a temperature sensor is disposed at a portion corresponding to a heat generation region of each heater part. These heater parts 154A to 154E and the respective temperature sensors are electrically connected to the controller 70. When such a substrate processing apparatus 150 is used, it is possible to clean the process chamber 30 more uniformly from the upstream side to the downstream side in the gas flow direction. In FIG. 8, the vicinity of the heater part 154E is positioned on the upstream side of the gas flow, the vicinity of the heater part 154A is positioned on the downstream side of the gas flow, and the vicinity of the heater part 154C is positioned on the midstream side of the gas flow.

### EXPLANATION OF REFERENCE NUMERALS

10: substrate processing apparatus
30: process chamber
30A: upper zone (a zone positioned on the downstream side in the gas flow direction)
30B: middle zone (a zone positioned on the midstream side in the gas flow direction)
30C: lower zone (a zone positioned on the upstream side in the gas flow direction)
40: process gas supply system
50: cleaning gas supply system
60: heater
60A: heater part
60B: heater part
60C: heater part
70: controller (control part)
80: nozzle
150: substrate processing apparatus
152: process furnace
154: heater
200: wafer
S210: loading step
S220: film-forming step
S230: unloading step
S260: cleaning step
S270: pre-coating step

## Claims

1. A method of cleaning a process chamber in which a film-forming process is performed on a substrate, comprising:
dividing an inside of the process chamber, into which a cleaning gas is to be supplied, into three or more zones in a gas flow direction and heating the inside of the process chamber such that, in the process chamber, a temperature difference between a zone positioned on an upstream side in the gas flow direction and a zone adjacent to the zone positioned on the upstream side is greater than a temperature difference between a zone positioned on a downstream side in the gas flow direction and a zone adjacent to the zone positioned on the downstream side; and
supplying the cleaning gas into the process chamber after the act of heating.

2. The method of Claim 1, wherein in the act of heating, the inside of the process chamber is heated such that, in the process chamber, a temperature of the zone positioned on the upstream side in the gas flow direction is lower than a temperature of the zone positioned on the downstream side in the gas flow direction.

3. The method of Claim 1 or 2, wherein in the act of heating, the inside of the process chamber is heated such that, in the process chamber, a temperature of the zone positioned on the upstream side in the gas flow direction is lower than a temperature of a zone positioned on a midstream side in the gas flow direction.

4. The method of any one of Claims 1 to 3, wherein in the act of heating, the inside of the process chamber is heated such that, in the process chamber, an etching rate of a deposit adhered to an inner surface of the process chamber is lower on the upstream side in the gas flow direction than on the downstream side in the gas flow direction.

5. The method of any one of Claims 1 to 4, wherein in the act of heating, the inside of the process chamber is heated such that, in the process chamber, an etching rate of a deposit adhered to an inner surface of the process chamber is substantially the same on the downstream side in the gas flow direction and on a midstream side in the gas flow direction.

6. The method of any one of Claims 1 to 5, wherein a deposit adhered to an inner surface of the process chamber include a nitride film, and the cleaning gas contains a halogen element.

7. The method of any one of Claims 1 to 6, wherein a deposit adhered to an inner surface of the process chamber include a film containing Si and N, and the cleaning gas contains a fluorine element.

8. The method of any one of Claims 1 to 7, wherein the cleaning gas contains at least one or more selected from the group of F₂, HF, NF₃, and CF₄.

9. The method of any one of Claims 1 to 8, wherein the cleaning gas is supplied from the upstream side toward the downstream side of the process chamber.

10. The method of any one of Claims 1 to 9, wherein a gas supply nozzle configured to be capable of supplying the cleaning gas is connected to the upstream side of the process chamber, and
wherein the cleaning gas is supplied to the upstream side of the process chamber via the gas supply nozzle.

11. The method of Claim 10, wherein a second gas supply nozzle configured to be capable of supplying the cleaning gas to the downstream side of the process chamber compared to a first gas supply nozzle as the gas supply nozzle is connected to the process chamber, and
wherein the cleaning gas is supplied via the first gas supply nozzle to the upstream side of the process chamber and is supplied via the second gas supply nozzle to the downstream side of the process chamber compared to the first gas supply nozzle.

12. The method of Claim 11, wherein the second gas supply nozzle includes an extending portion which extends from the upstream side toward the downstream side of the process chamber, and a plurality of injection ports formed to be spaced apart in the extending portion in a direction where the extending portion extends, and
wherein the cleaning gas is supplied to the process chamber via the plurality of injection ports from the extending portion of the second gas supply nozzle.

13. The method of any one of Claims 1 to 12, further comprising, after the act of supplying, performing a pre-coating process of supplying a first gas containing a first element and a second gas containing a second element to form, on an inner surface of the process chamber, a film with a ratio of the first element to the second element being equal to or more than a ratio of the first element to the second element of a film formed on the substrate by the film-forming process.

14. The method of Claim 13, wherein an internal pressure of the process chamber when performing the pre-coating process is set to be lower than an internal pressure of the process chamber when performing the film-forming process.

15. A method of manufacturing a semiconductor device, comprising:
loading a substrate into a process chamber;
heating an inside of the process chamber and performing a film-forming process of supplying a process gas into the process chamber to form a film on the substrate;
unloading a processed substrate from the process chamber; and
dividing the inside of the process chamber, into which a cleaning gas is to be supplied, into three or more zones in a gas flow direction of the cleaning gas, heating the inside of the process chamber such that, in the process chamber, a temperature difference between a zone positioned on an upstream side in the gas flow direction and a zone adjacent to the zone positioned on the upstream side is greater than a temperature difference between a zone positioned on a downstream side in the gas flow direction and a zone adjacent to the zone positioned on the downstream side, and supplying the cleaning gas to the heated inside of the process chamber to remove a deposit containing a film-forming material adhered to an inner surface of the process chamber.

16. A substrate processing apparatus comprising:
a process chamber in which a substrate is processed;
a process gas supply system configured to supply a process gas into the process chamber;
a cleaning gas supply system configured to supply a cleaning gas into the process chamber;
a heater configured to be capable of dividing an inside of the process chamber into three or more zones in a gas flow direction of the cleaning gas and heating each of the zones separately; and
a controller configured to control the heater, the process gas supply system, and the cleaning gas supply system,
wherein the controller is configured to be capable of controlling the heater so as to heat the inside of the process chamber such that, in the process chamber, a temperature difference between a zone positioned on an upstream side in the gas flow direction and a zone adjacent to the zone positioned on the upstream side is greater than a temperature difference between a zone positioned on a downstream side in the gas flow direction and a zone adjacent to the zone positioned on the downstream side, and is configured to be capable of controlling the cleaning gas supply system so as to supply the cleaning gas into the heated inside of the process chamber.

17. A program that causes a computer to perform a process comprising:
dividing an inside of a process chamber, into which a cleaning gas is to be supplied, into three or more zones in a gas flow direction and heating the inside of the process chamber such that, in the process chamber, a temperature difference between a zone positioned on an upstream side in the gas flow direction and a zone adjacent to the zone positioned on the upstream side is greater than a temperature difference between a zone positioned on a downstream side in the gas flow direction and a zone adjacent to the zone positioned on the downstream side; and
supplying the cleaning gas into the process chamber heated in the act of heating.
